(19) Europäisches Patentamt
European Patent Office
Office européen des brevets

(11) **EP 1 808 509 A1**

(12) **EUROPEAN PATENT APPLICATION**
published in accordance with Art. 158(3) EPC

(43) Date of publication:
**18.07.2007 Bulletin 2007/29**

(51) Int Cl.:
*C23C 14/46* (2006.01)    *C23C 14/34* (2006.01)
*G03F 1/16* (2006.01)     *H01L 21/027* (2006.01)
*H01L 21/285* (2006.01)

(21) Application number: **05805110.3**

(22) Date of filing: **21.10.2005**

(86) International application number:
**PCT/JP2005/019406**

(87) International publication number:
**WO 2006/049022 (11.05.2006 Gazette 2006/19)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **04.11.2004 JP 2004320284**

(71) Applicant: **Asahi Glass Company, Limited Chiyoda-ku, Tokyo 100-8405 (JP)**

(72) Inventors:
• **SUGIYAMA, Takashi,
Asahi Glass Company, Limited
Yokohama-shi, Kanagawa 221-8755 (JP)**

• **UNO, Toshiyuki,
Asahi Glass Company, Limited
Yokohama-shi, Kanagawa 221-8755 (JP)**
• **TAKAKI, Satoru,
Asahi Glass Company, Limited
Yokohama-shi, Kanagawa 221-8755 (JP)**

(74) Representative: **Müller-Boré & Partner
Patentanwälte
Grafinger Strasse 2
81671 München (DE)**

(54) **ION BEAM SPUTTERING EQUIPMENT AND METHOD FOR FORMING MULTILAYER FILM FOR REFLECTIVE MASK BLANK FOR EUV LITHOGRAPHY**

(57)    A film deposition method for a multilayer for a EUV mask blank by which a defect caused by the mixing of a particle in the layer during film formation can be prevented and an ion beam sputtering apparatus suitable for the method are presented.

A film deposition method for forming a multilayer for a reflective-type mask blank for EUV lithography on a film deposition substrate by using an ion beam sputtering method, the film deposition method being **characterized in that** a sputtering target and a film deposition substrate are disposed at opposed positions with a predetermined space, and ion beams are injected to the sputtering target from an ion source which is disposed at a position out of the region where particles move linearly from the film deposition substrate toward the sputtering target.

Fig. 1

**Description**

TECHNICAL FIELD

The present invention relates to an ion beam sputtering apparatus suitable for forming a multilayer for a reflective-type mask blank for EUV (extreme ultraviolet) lithography and a method for depositing a multilayer for a reflective-type mask blank for EUV lithography by using an ion beam sputtering method.

BACKGROUND ART

In the semiconductor industry, a photolithography method using visible light or ultraviolet light has been employed as a technique for writing, on a Si substrate or the like, a fine pattern, which is required for writing an integrated circuit comprising such a fine pattern. However, the conventional exposure techniques using light exposure have been close to the limit while semiconductor devices have had finer patterns at an accelerated pace. In the case of light exposure, it is said that the resolution limit is about 1/2 of exposure wavelength, and even if an $F_2$ laser (157 nm) is employed, it is estimated that the resolution limit of a pattern is about 70 nm. From this point of view, EUV lithography which is an exposure technique using EUV light having a shorter wavelength than. $F_2$ laser has been considered as being promising as an exposure technique for 70 nm or below. In this description, it should be noted that the EUV light means a ray having a wavelength in a soft X-ray region or a vacuum ultraviolet ray region, specifically, a ray having a wavelength of about 10 to 20 nm.

It is impossible to use EUV light in conventional dioptric systems as in photolithography using visible light or ultraviolet light since EUV light is apt to be absorbed by any substances and since substances which absorb EUV light have a refractive index close to 1. For this reason, a catoptric system, i.e. a combination of a reflective photomask and a mirror is employed in EUV light lithography.

A mask blank is a laminated member for fabrication of a photomask, which has not been patterned yet. When a mask blank is used for a reflective photomask, the mask blank has a structure wherein a substrate made of glass or the like has a reflective layer for reflecting EUV light and an absorbing layer for absorbing EUV light formed thereon in this order. The reflective layer is normally a multilayer film, which comprises films made of high refractive index material and films of low refractive index material alternately laminated to increase the light reflectance when irradiating the layer surface with a ray, more specifically, when irradiating the layer surface with EUV light. In such a multilayer film, Mo is widely employed for the high refractive index material and Si is widely employed for the low refractive index material. Although a magnetron sputtering method has conventionally been employed for forming the multilayer film (see Patent Document 1), use of an ion beam sputtering method is becoming a main stream because a film of less defect and high accuracy can be obtained with it (see Patent Document 2).

In the ion beam sputtering, a thin film of a target material is formed on a substrate by placing in a chamber inside of which is kept to be a high vacuum state a sputtering target (hereinbelow, referred possibly to the target) and a substrate on which a film is to be deposited, respectively, and ion beams are injected at a high speed from an ion source attached to a chamber wall to the sputtering target to discharge atoms (particles) of the material constituting the target upward from the target surface by the energies of ions entering into the target, i.e., conducting sputtering whereby the sputtered atoms are deposited on the substrate.

In this process, in the ion beams irradiated to the sputtering target, there are ions reflected at the target surface or ions scattered (bouncing ions), which do not contribute the sputtering of the target (without entering into the inside), and these bouncing ions reach the substrate in a fairly large amount. Since these bouncing ions reach the substrate at a high speed without losing a sufficient amount of kinetic energy that the ions possess originally, they sputter the film material deposited on the substrate or roughen the film surface when they enter into the substrate, whereby the characteristics of the film to be formed become deteriorated.

Further, when bounding ions reflected or scattered at a high speed on the target surface enter into the inner walls of the chamber or an internal mechanism, they sputter the atoms of materials constituting these constituent members. The sputtered atoms enter as impurities into the film deposited on the substrate. Thus, the conventional method caused degradation in the quality of the film.

Patent Documents 3 and 4 describe ion beam sputtering apparatuses for preventing the deterioration of the film quality caused by such bouncing ions. In the apparatus of Patent Document 3, the deterioration of the film quality caused by the bouncing ions can be prevented by arranging a sputtering target and a film forming substrate at opposed positions in a chamber, injecting ion beams from an ion source to the sputtering target from an oblique direction, and trapping bouncing ions reflected or scattered at the target surface by means of a trapping member located so as to face the ion source. On the other hand, in the apparatus of Patent Documents 4, the deterioration of the film quality by bouncing ion can be prevented by providing an ion trapping ring between the sputtering target and the substrate to be treated.

However, in the view of the system principle that the atoms of the material constituting the target are sputtered by ions entering into the target, it is practically impossible to lead all the sputtered atoms to an intended direction, specifically toward the substrate. Therefore, a part of the sputtered atoms deposit on the inner walls of the chamber or the constituent members in the chamber to form deposited films.

Since these deposited films do not bond strongly to the inner walls or the like of the chamber, they sometimes separate from the inner walls or the like of the chamber. If particles of the deposited films separated from the inner wall or the like enter into films being deposited, the mask blank to be manufactured has defects.

In the conventional ion beam sputtering apparatuses, the defect caused by the mixing of particles in a film being deposited was immaterial in comparison with the deterioration of the film quality caused by bouncing ions. Accordingly, it was negligible depending on purposes of use of the film (for example, a film attached to a surface of an architectural window glass for absorbing heat-ray, or the like) to be formed by using ion beam sputtering. However, in the case of a reflective-type mask blank for EUV lithography, such minor defect becomes problematic. The reflective-type mask blank for EUV lithography would be required that a defect of 30 nm or larger in a multilayer film including a reflective film and a protective layer formed thereon is at most 0.005 number/cm$^2$. However, it was impossible for the conventional ion beam sputtering apparatuses to reduce the defect to such a level.

Further, there is another point to keep in mind in the principle of the ion beam sputtering. In the ion beam sputtering, a dense plasma is formed by electric discharge in the ion source. Since the ion source has at least its part, specifically, a beam discharging portion with a beam accelerating electrode in the chamber, it can be considered as one of major sources of generating the particles. Further, there is a case that some particles sputtered from the target are deposited on the ion source, and the deposited material separates by any cause to become particles.

When the particles generated at the ion source enter into the film being deposited, the mask blank has defects.

Patent Document 1: JP-A-2002-222764

Patent Document 2: JP-A-2004-246366

Patent Document 3: JP-A-7-90579

Patent Document 4: JP-A-2004-137557

DISCLOSURE OF THE INVENTION

OBJECT TO BE ACCOMPLISHED BY THE INVENTION

In order to solve such..problems, the present invention is to provide a method for forming a multilayer film for an EUV mask blank, preventing the defect of entering particles in a film during film formation and an ion beam sputtering apparatus suitable for this method.

MEANS TO ACCOMPLISH THE OBJECT

In order to achieve the above-mentioned object, the present invention is to provide an ion beam sputtering apparatus comprising a chamber with a vacuuming device capable of maintaining the chamber in a vacuum state, a sputtering target made of a material forming a thin film deposited on the surface of a film deposition substrate and an ion source for irradiating ion beams comprising ions extracted from plasma onto the sputtering target, the ion beam sputtering apparatus being characterized in that the sputtering target and the film deposition substrate are disposed at opposed positions so that the relative distance is from 63 to 141 cm (a first ion beam sputtering apparatus).

Further, according to the present invention, there is provided an ion beam sputtering apparatus comprising a chamber with a vacuuming device capable of maintaining the chamber in a vacuum state, a sputtering target made of a material forming a thin film deposited on the surface of a film deposition substrate and an ion source for irradiating ion beams comprising ions extracted from plasma onto the sputtering target, the ion beam sputtering apparatus being characterized in that the sputtering target and the film deposition substrate are disposed at opposed positions with a predetermined space, and the ion source is disposed at a position out of the region where particles move linearly from the film deposition substrate toward the sputtering target (a second ion beam sputtering apparatus).

Further, according to the present invention, there is provided an ion beam sputtering apparatus comprising a chamber with a vacuuming device capable of maintaining the chamber in a vacuum state, a sputtering target made of a material forming a thin film deposited on the surface of a film deposition substrate and an ion source for irradiating ion beams comprising ions extracted from plasma onto the sputtering target, the ion beam sputtering apparatus being characterized in that in the chamber, a device for deflecting ion beams by the action of a magnetic field is provided in the chamber (a third ion beam sputtering apparatus).

Further, according to the present invention, there is provided a film deposition method for forming a multilayer film for a reflective-type mask blank for EUV lithography on a film deposition substrate by using an ion beam sputtering method, the film deposition method being characterized in that a sputtering target and a film deposition substrate are disposed at opposed positions so that the relative distance is from 63 to 141 cm (a first film deposition method).

Further, according to the present invention, there is provided a film deposition method for forming a multilayer film for a reflective-type mask blank for EUV lithography on a film deposition substrate by using an ion beam sputtering method, the film deposition method being characterized in that a sputtering target and a film deposition substrate are disposed at opposed positions with a predetermined space, and ion beams are injected to the sputtering target from an ion source which is disposed at a position out of the region where particles move linearly from the film deposition substrate toward the sputtering target (a second film deposition method).

Further, according to the present invention, there is provided a film deposition method for forming a multilayer film for a reflective-type mask blank for EUV lithography on a film deposition substrate by using an ion beam sputtering method, the film deposition method being characterized in that a sputtering target and a film deposition substrate are disposed at opposed positions with a predetermined space, and ion beams from an ion source are deflected by the action of a magnetic field to be injected into the sputtering target (a third film deposition method).

Further, according to the present invention, there is provided a film deposition method for forming a multilayer film for a reflective-type mask blank for EUV lithography on a film deposition substrate by using an ion beam sputtering method, the film deposition method being characterized in that temperature changes in the vacuum atmosphere in ion beam sputtering are kept to be less than 10°C (a fourth film deposition method) .

EFFECTS OF THE INVENTION

According to the first film deposition method of the present invention, particles from an inner wall or the like of the chamber can be prevented from reaching the substrate during film formation. According to the first film deposition method of the present invention, a high-quality reflective-type mask blank for EUV lithography wherein there is no impermissible defect, specifically, a defect of 30 nm or larger in the multilayer film including a reflective layer and a protective layer formed thereon is at most 0.05 number/cm$^2$, particularly, at most 0.005 number/cm$^2$, can be produced.

The first ion beam sputtering apparatus of the present invention is suited for carrying out the above-mentioned first film deposition method of the present invention.

According to the second film deposition method of the present invention, the particles generated at the ion source can also be presented from reaching the substrate during film formation, whereby a high-quality reflective-type mask blank for EUV lithography wherein there is no impermissible defect, specifically, a defect of 30 nm or larger in the multilayer film including a reflective layer and a protective layer formed thereon is at most 0.005 number/cm$^2$, can be produced.

The second ion beam sputtering apparatus of the present invention is suited for carrying out the above-mentioned second film deposition method of the present invention.

In the third film deposition method of the present invention, ion beams from the ion source are deflected to be injected into the sputtering target. Accordingly, even in a case of using a plurality of ion sources disposed at symmetrical positions, the possibility that the atoms sputtered by ion beams move toward another ion source, can be reduced. With such measures, it is possible to reduce the possibility of generating particles at the ion source.

Further, when ion beams are deflected to be injected into the sputtering target in a vertical direction, almost the sputtered atoms move toward the film deposition substrate, and the movement in another direction, specifically, the direction of an inner wall of the chamber or another ion source can be minimized. As a result, generation of particles at the inner wall of the chamber or another ion source can remarkably be reduced.

According to the third film deposition method of the present invention, a high-quality reflective-type mask blank for EUV lithography wherein there is no impermissible defect, specifically, a defect of 30 nm or larger in the multilayer film including a reflective layer and a protective layer formed thereon is at most 0.005 number/cm$^2$, can be produced.

The third ion beam sputtering apparatus of the present invention is suited for carrying out the above-mentioned third film deposition method of the present invention.

In the fourth film deposition method of the present invention, all temperature changes in the chamber, including a temperature change of atmosphere in the chamber, a temperature change of an inner wall of the chamber and a temperature change of a constituent member in the chamber are always kept to be less than 10°C, whereby the separation of the deposited film from the inner wall or the like in the chamber can be prevented. According to the fourth film deposition method of the present invention, a high-quality reflective-type mask blank for EUV lithography wherein there is no impermissible defect, specifically, a defect of 30 nm or larger in the multilayer film including a reflective layer and a protective layer formed thereon is at most 0.005 number/cm$^2$, can be produced.

Further, in the fourth film deposition method of the present invention, the film deposition operations can be conducted in a large number of batches without removing the deposited films on the inner wall and so on in the chamber.

BRIEF DESCRIPTION OF DRAWINGS

Fig. 1 is a schematic view showing the first ion beam sputtering apparatus of the present invention.
Fig. 2 is a schematic view showing the second ion beam sputtering apparatus of the present invention.
Fig. 3 is a schematic view showing the third ion beam sputtering apparatus of the present invention.

MEANINGS OF SYMBOLS

| 1, 1', 1": | ion beam sputtering apparatus |
| 10: | chamber |
| 20: | target unit |
| 21: | sputtering target of high refractive index material |
| 22: | sputtering target of low refractive index material |
| 23, 24: | sputtering target of protective film material |
| 25: | base |
| 200: | sputtered atoms |
| 30: | substrate |
| 40: | ion source |
| 41 | beam accelerating electrode |
| 400: | ion beams |
| 50: | baffle plate |
| 51: | particle trap |
| 60: | ion beam deflecting device |
| 70: | reflecting plate |
| 100: | vacuuming device (vacuum pump) |

BEST MODE FOR CARRYING OUT THE INVENTION

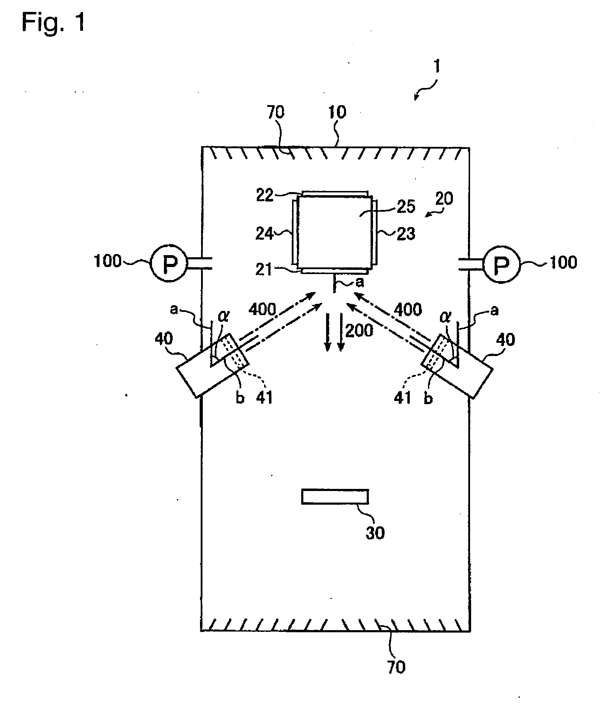

The present invention relates to a method for forming a multilayer film for a reflective-type mask blank for EUV lithography (hereinbelow, referred to as the "EUV mask blank") on a substrate on which a film is to be formed by using an ion beam sputtering method (hereinbelow, may possibly be referred,to as "the film deposition method of the present invention") and an ion beam sputtering apparatus suitable for this method. The multilayer film for an EUV mask blank includes a reflective layer formed by laminating alternately a film of high reflective index material and a film of low refractive index material on a substrate and a protective layer formed optionally on the reflective layer. The EUV mask blank is formed by forming on this multilayer film a buffer layer and an absorbing layer in this order.
In the following, description will be made further on the present invention with reference to figures. Fig. 1 is a schematic view showing an ion beam sputtering apparatus (the first ion beam sputtering apparatus of the present invention) usable when the first embodiment of the film deposition method of the present invention is employed. In the ion beam sputtering apparatus 1 shown in Fig. 1, a chamber 10 is provided with a vacuuming device (vacuum pump) 100 by which the inside of the chamber can be maintained in a vacuumed state. In the chamber 10, a sputtering target 21 and a substrate on which a film is deposited (hereinbelow, referred possible to as the substrate) 30 are disposed facing each other with a predetermined space. On wall surfaces of the chamber 10, two ion sources 40 are disposed at positions to be symmetric laterally in the figure. Each ion source 40 discharges ions extracted from plasma, as ion beams 400. The ion beams 400 from the ion source 40 enter obliquely into the sputtering target 21. The two ion sources 40 are disposed so that the directions of the ion beams 400 are symmetric with respect to a normal line a on the sputtering target 21. Hereinbelow, the symmetric arrangement of ion sources in the description means that the ion sources are disposed so that the directions of ion beams are symmetric with respect to a normal line on the sputtering target.
The ion beams 400 incident into the sputtering target 21 sputter the atoms constituting the sputtering target 21. The sputtered atoms 200 move toward the substrate for film deposition 30 to form a thin film of a film deposition material on the film deposition substrate 30. The sputtering target is formed of a target unit 20 comprising a plurality of sputtering targets 21, 22, 23 and 24, each corresponding to a film to be formed, which are disposed on a rotatable base 25.
In order to laminate films having different compositions on the film deposition substrate 30, ion beams 400 are incident into the sputtering targets 21, 22, 23, 24 of different material while the base 25 is rotated. By repeating these procedures, a multilayer film is formed on the film deposition substrate 30.

The first embodiment of the film deposition method of the present invention (hereinbelow, referred to as "the first film deposition method of the present invention") is characterized in that the sputtering target 21 and the film deposition substrate 30 are disposed at opposed positions so that the relative distance is from 63 to 141 cm.

On the assumption that Mo particles exist in the chamber 10 when a Mo/Si reflective layer is formed as the multilayer film, the moving distance of the particles (Mo particles) in the chamber was obtained by the following procedures.

On the assumption that Ar gas molecules having an averaged energy of gas molecules at the room temperature (298(K)) and Mo particles having a diameter of 30 nm exist in the chamber 10, the moving distance of the Mo particles by the collisions of plural times of the Ar gas molecules to the Mo particles so that the equivalent kinetic momentum of the energy of the gas molecules is given to the Mo particles, was obtained. The average velocity $C_{ave}$ (m/s) of the gas molecules at a temperature T(K) is expressed by the following formula:

$$C_{ave}=(8\underline{k}T/\pi m)^{1/2} \quad (m: \text{ mass of gas molecules})$$

Average velocities of the Ar gas molecules at 298(K) and the Mo particles of diameter of 30 nm are 397 (m/s) and 0.269 (m/s) respectively. Accordingly, the kinetic momentums of the Ar gas molecules at 298(K) and the Mo particles of diameter of 30 nm are respectively $2.64\times10^{-23}$ (kg·m/s) and $3.89\times10^{-20}$ (kg·m/s).

On the other hand, on the assumption that the partial pressure p of the Ar gas in the chamber 10 is $1.33\times10^{-2}$ (Pa), a mean free path $\lambda$ of the Mo particles of diameter of 30 nm in the Ar gas atmosphere can be obtained by the following approximation:

$$\lambda=kT/\sigma p \quad (\sigma: \text{ cross-sectional area of collision})$$

Based on the formula, the mean free path of the Mo particles in the Ar gas atmosphere is $4.26\times10^{-4}$ (m).

Here, the number of collisions necessary to give the equivalent kinetic momentum to the Mo particles of diameter of 30 nm by the Ar gas molecules is $3.89\times10^{-20}/2.64\times10^{-23}=1475.5$ times. When the obtained value is multiplied by the mean free path of the Mo particles as described above, the moving distance of the Mo particles caused by the collisions of plural times of the Ar gas molecules against the Mo particles so that the equivalent kinetic momentum is given, can be obtained as follows:

$$1475.5\times4.26\times10^{-4}\fallingdotseq63 \text{ cm}$$

When the relative distance of the spattering target 21 to the film deposition substrate 30 is at least 63 cm, the kinetic momentum of the particles around the sputtering target 21, specifically, the particles from the target unit 20 and the inner walls of the chamber 10 in the vicinity of the target unit 20 and the particles generated at the ion sources 40, is attenuated by the collisions of the particles to the gas molecules (for example, Ar gas molecules) in the chamber whereby the particles can not reach the film deposition substrate 30. At these locations in the chamber 10, particles are most likely to be generated. Accordingly, when the relative distance of the sputtering target 21 to the film deposition substrate 30 is at least 63 cm, the particles from the inner walls or the like of the chamber 10 or the particles from the ion sources 40 can be prevented from reaching the film deposition substrate 30.

On the other hand, if the relative distance of the sputtering target 21 to the film deposition substrate 30 exceeds 141 cm, the film deposition rate is too low and the film deposition rate at a practical level cannot be maintained.

When ion beams 400 from the ion sources 40 are incident obliquely into the sputtering target 21, the films can uniformly be deposited because a plurality of ion sources 40 are disposed at symmetric positions as shown in Fig. 1. The number of ion sources is not limited to two as shown in Fig. 1. The number may be three, four or more as long as they can be located at positions symmetric to each other, which would rather be preferred in order to deposit uniformly the films. In the case of arranging ion sources 40 at symmetric positions, the atoms sputtered by ion beams 400 move in a fairly large amount in the directions of the other ion sources 40. However, when three ion sources are used, the amount of movement of the sputtered atoms in the directions of the other ion sources 40 can be reduced.

The symmetric arrangement of a plurality of ion sources is preferred as well in the second, the third and the fourth film deposition methods of the present invention.

It is preferred that a width of each of the sputtering targets 21, 22, 23, 24 is narrower than the width of the ion beams 400 from each ion source 40. When the width of the sputtering target 21, 22, 23 or 24 is wider than the width of the ion beams 400, the sputtering target 21, 22, 23 or 24 has a portion where the ion beams 400 are not incident and a film may accumulate on this portion. If particles resulted from the film separated from the portion enter into a film during film formation, the mask blank formed may have defects. When the width of the sputtering target 21, 22, 23 or 24 is narrower than the width of the ion beams 400, the ion beams 400 cover entirely the sputtering target 21, 22, 23 or 24 whereby the accumulation of such film can be prevented. The formation of the sputtering target 21, 22, 23 or 24 to have a narrower width than the ion beams 400 is preferred as well in the second, the third and the fourth film deposition method of the present invention described below.

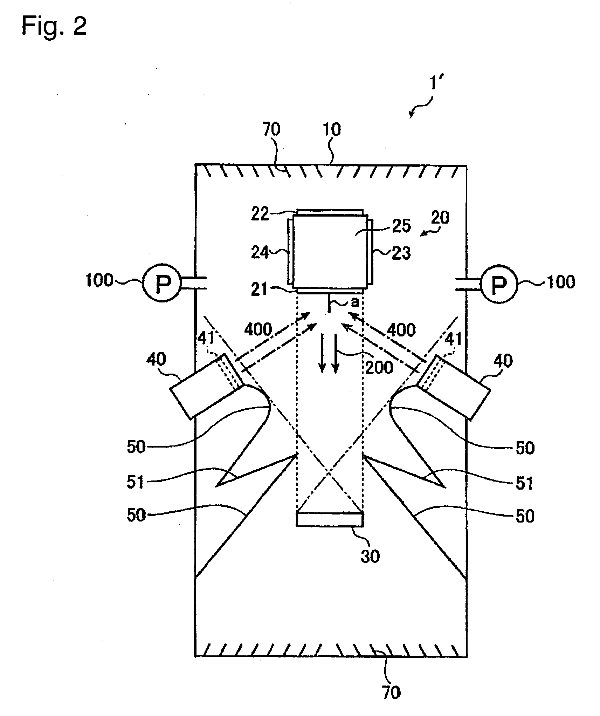

Fig. 2 is a schematic view showing an ion beam sputtering apparatus (the second ion beam sputtering apparatus) usable when the second embodiment of the film deposition method of the present invention is employed. In Fig. 2, the same reference numerals as in Fig. 1 are used in the same meaning as in Fig. 1.

In the second embodiment of the film deposition method of the present invention (hereinbelow, referred to as "the second film deposition method of the present invention") is characterized in that ion beams are injected to a sputtering target from an ion source which is disposed at a position out of the region where particles move linearly from a film deposition substrate toward the sputtering target.

In the ion beam sputtering apparatus 1' in Fig. 2, a device useful for carrying out the second film deposition method of the present invention is shown. Specifically, baffle plates 50 are attached to the inner walls of the chamber 10 from the locations where the ion sources 40 are disposed, toward the film deposition substrate 30 so that the baffle plates extend in the direction of the center of chamber 10. The presence of the baffle plates 50 defines the region where particles move linearly from the film deposition substrate 30 toward the sputtering target 21 as indicated by broken lines or two-dotted chain lines in Fig. 2.

The particles in this description do not indicate specified, embodies particles such as the particles from the inner walls or the like of the chamber 10, the particles generated at the ion sources 40 or the sputtered atoms from the sputtering target 21, but indicate imaginary particles used in the following explanation. The region where the particles move linearly from the film deposition substrate 30 toward the sputtering target 21 means the range that the imaginary particles can move linearly without collision against the inner walls of the chamber 10 or structural members in the chamber 10 when the imaginary particles move from the substrate 30 toward the sputtering target 21 namely, in an upper direction in Fig. 2. In Fig. 2, the broken lines show the boarder of the region where the imaginary particles can move linearly in a direction of just above from the film deposition substrate 30 toward the sputtering target 21. The two-dotted chain lines in Fig. 2 show the boarder of the region where the imaginary particles can move linearly when they move in a direction of obliquely upward from the film deposition substrate 30 toward the sputtering target 21.

According to the second film deposition method of the present invention, ion sources 40 are disposed at positions out of the region where the imaginary particles can move linearly from the film deposition substrate 30 toward the sputtering target 21, namely, positions without belonging either the range shown by the broken line or the range shown by the two-dotted chain lines in Fig. 2. By arranging the ion sources 40 at such positions, the particles generated at the ion sources 40 can be prevented from moving to the film deposition substrate 30 by means of the baffle plates 50.

In the second film deposition method of the present invention, it is not necessary to dispose the entirety of each of the ion sources 40 at a position out of the region where the imaginary particles can move linearly from the film deposition substrate 30 toward the sputtering target 21. In the ion source 40, the portion generating particles is a beam discharge portion provided with a beam accelerating electrode 41. Accordingly, it is only necessary to dispose at least the beam accelerating electrode 41 at a position out of the region where the imaginary particles move linearly from the film deposition substrate 30 toward the sputtering target 21. Accordingly, it is possible to carry out the second film deposition method of the present invention without using the baffle plates 50 as in the ion beam sputtering apparatus 1' shown in Fig. 2. For example, in the ion beam sputtering apparatus 1 shown in Fig. 1, when an angle α formed by a normal line _a_ on the sputtering target 21 and a long axis b of the ion source 40 is made to be 45° or less, the beam accelerating electrode 41 is consequently set to the position out of the region where the imaginary particles move linearly from the film deposition substrate 30 toward the sputtering target 21 by the presence of a housing member for the ion source 40.

The ion beam sputtering apparatus 1' shown in Fig. 2 is provided with a structure useful for preventing the entering of the particles into a film during film formation. Specifically, a part of a baffle plate 50 is bent acutely toward the wall surface of the chamber 10 to form a deep concave portion 51. This concave portion 51 serves as a particle trap, so that the particles from the inner wall or the like of the chamber 10 or the particles generated at an ion source 40 are trapped by the concave portion 51.

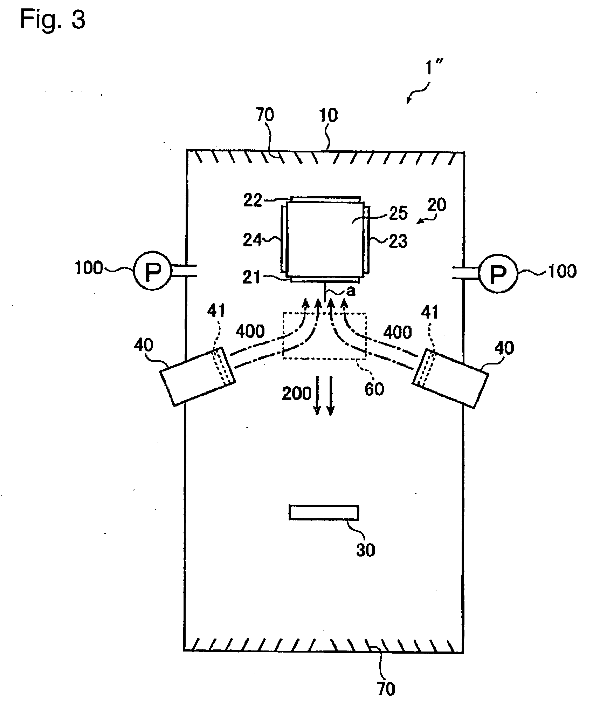

Fig. 3 is a schematic view showing an ion beam sputtering apparatus (the third ion beam sputtering apparatus) usable for the third embodiment of the film deposition method of the present invention. In Fig. 3, the same reference numerals as in Fig. 1 are used in the same meaning as in Fig. 1.

The third embodiment of the film deposition method of the present invention (hereinbelow, referred to as "the third film deposition method of the present invention") is characterized in that ion beams from an ion source are deflected by the action of a magnetic field to be injected into the sputtering target.

The ion beam sputtering apparatus 1'' shown in Fig. 3 is provided with a device for carrying out the second film deposition method of the present invention.

The ion beam sputtering apparatus 1'' shown in Fig. 3 has a device 60 for deflecting ion beams 400 (ion beam deflecting device) from an ion source 40 by the action of a magnetic field. The ion beams 400 from the ion source 40 is deflected by the ion beam deflecting device 60 to be injected into a sputtering target 21.

When the ion beams 400 are incident into the sputtering target 21 in an oblique direction, all the sputtered atoms do not always move toward the film deposition substrate 30 but move partly in other directions. For example, a part of the sputtered atoms move in a direction of inner wall of the chamber 10 or a direction of another ion source 40. In particular, when a plurality of ion sources 40 are arranged at symmetric positions, the sputtered atoms move toward other ion sources 40 in a fairly large amount whereby particles may be generated.

According to the third film deposition method of the present invention, the ion beams 400 from the ion sources 40 are deflected, so that the possibility of movement of the sputtered atoms toward other ion sources 40 can be reduced.

In the third film deposition method of the present invention, it is preferred to deflect the ion beams 400 from the ion sources 40 so that the ion beams are incident into the sputtering target 21 in a vertical direction.

When the ion beams 400 are incident into the sputtering target 20 in a vertical direction, the most part of the sputtered atoms is moved toward the film deposition substrate 30 whereby the possibility that particles move to the other directions, specifically, the directions of the inner walls of the chamber 10 or the other ion source 40, can be reduced. Thus, the generation of the particles in the chamber 10 can be reduced.

In order to deflect the ion beams by the action of a magnetic field, it is only necessary to dispose a pair of electromagnets at both sides on the path of the ion beams so as to produce a magnetic field in a direction perpendicular to the traveling direction of the ion beams, for example. The deflection of the ion beams can be adjusted by changing the range or the strength of the magnetic field produced.

According to the fourth embodiment of the film deposition method of the present invention (hereinbelow, referred as "the fourth film deposition method of the present invention"), temperature changes in the vacuum atmosphere of ion beam sputtering, i.e., temperature changes in the chamber 10 are always kept to be less than 10°C. Here, the temperature changes in the chamber 10 indicate all temperature changes caused possibly in the chamber 10 kept to have a predetermined degree of vacuum necessary for depositing films, such as a temperature change of the vacuum atmosphere in the chamber 10, a temperature change of the inner walls of the chamber 10, a temperature change of structural members such as an ion source 40, the target unit 20, the film deposition substrate 30 or the like in the chamber 10, for example.

In the film deposition process for a multilayer film for an EUV mask blank, a reflective layer is formed by laminating alternately a film of high refractive index material and a film of low refractive index material plural times, specifically, 40 times, for example, on the film deposition substrate 30, and a protective layer is formed thereon. In order to laminate films having different compositions in this manner, the ion beams 400 are incident into different sputtering targets 21, 22, 23, 24 depending on films to be deposited while the base 25 is rotated. In the ion beam sputtering, it is necessary to control the interior of the chamber 10 to have a predetermined temperature at only the stage of conducting sputtering actually, namely, at only the stage of sputtering atoms by injecting ion beams 400 into the sputtering target 21, 22, 23 or 24. At another stage, for example, when the base 25 is rotated in order to change sputtering target 21, 22, 23 or 24 to be subjected to the injection of the ion beam 400, it is unnecessary to maintain the temperature of the interior of the chamber 10 to have the same temperature level. Conventionally, there was an idea that it was undesirable to keep the temperature of the interior of the chamber 10 to be the same temperature level from the viewpoint of cost performance. Also, at the stage that the film deposition substrate 30 is placed in the chamber 10 or the stage that the substrate after film deposition is taken from the chamber 10 too, there was an idea that it was unnecessary to keep the temperature of the interior of the chamber 10 to be a predetermined temperature level. Therefore, there was a fairly large temperature difference in the chamber 10 between the stage of conducting sputtering actually and stages other than the stage of sputtering. As a result, a fairly large temperature change took place in the chamber 10 when the multilayer film was formed. However, such temperature changes may cause the separation of the deposited films from the inner walls of the chamber 10 or the ion sources 40 to produce particles.

As described above, since the adverse affect due to the particles from the inner walls or the like of the chamber 10 was considered to be negligible depending on purposes of use of the film to be formed, persons did not acknowledged so far as a problem. However, in the case of EUV mask blanks, even a fine defect may cause a problem, and accordingly, it is desirable to reduce as possible the occurrence of particles in the chamber 10.

According to the fourth film deposition method of the present invention, the temperature changes in the chamber 10 are always kept to be less than 10°C whereby the separation of the deposited films from the inner walls of the chamber 10 or the ion sources 40 can be prevented.

In the fourth film deposition method of the present invention, the temperature changes in the chamber 10 are kept to be less than 10°C throughout all the processes from the stage that the film deposition substrate 30 is placed in the chamber 10 to the stage that the substrate after film deposition is taken out the chamber 10. For this purpose, placement of the film deposition substrate 30 in the chamber 10 and removal of the substrate after film deposition from the chamber 10 are conducted using a load-lock.

As an example of conducting the fourth film deposition method of the present invention, temperature sensors are located at portions where the formation of the deposited films is expected, such as, for example, inner walls of the chamber 10 or ion sources 40, and temperature changes in the chamber 10 are controlled to be always less than 10°C using a heating device or cooling device while the temperatures at these portions are observed. It is more preferred that the temperature changes in the chamber 10 are less than 1°C.

In order to keep the temperature changes in the chamber 10 to be always less than 10°C throughout all the processes from the stage that the film deposition substrate 30 is placed in the chamber 10 to the stage that the substrate after film deposition is taken out the chamber 10 in the fourth film deposition method of the present invention, it is also preferred to form a plurality of multilayer films consecutively.

When a plurality of multilayer films are formed consecutively in the forth film deposition method of the present invention, the thickness of the deposited films on the inner walls or the like of the chamber 10 is increased, and finally, the deposited films are separated due to the gravity and so on even though the temperature changes in the chamber 10 are small. In this case, it is necessary to remove the deposited films on the inner walls or the like in the chamber 10. However, it is possible to form consecutively multilayer films in a larger batch numbers until it becomes necessary to remove the deposited films on the inner walls or the like in the chamber 10.

The above-mentioned first to fourth film deposition methods of the present invention may be carried out independently or may be carried out in a combination of a plurality of the methods. In order to prevent particles from entering into a film during film formation, it is preferred to combine any of the first to fourth film deposition methods of the present invention.

The ion beam sputtering apparatuses 1, 1', 1" shown in Figs. 1 to 3 have another structure useful for preventing the particles from entering into a film during film formation. Description will be made as to such a structure as follows.

In the ion beam sputtering apparatuses 1, 1', 1" shown in Figs. 1 to 3, the sputtering target 21 of high refractive index material and the sputtering target 22 of low refractive index material, which are used for forming the reflective layer in the multilayer film, are formed at positions on the base 25 so as to oppose to each other. As described above, when the multilayer film is formed on the film deposition substrate, ion beams 40 are injected to the different sputtering targets 21, 22, 23, 24 while the base 25 is rotated. In this case, there was possibility that the sputtered atoms contaminate the other sputtering targets which did not contribute the sputtering. Since the sputtering target 21 of high refractive index material and the sputtering target 22 of low refractive index material, which are used when the reflective layer is formed, are formed at positions on the base 25 so as to oppose to each other, in the ion beam sputtering apparatuses 1, 1', 1" shown in Figs. 1 to 3, the possibility that the sputtered atoms from a sputtering target contaminate the other sputtering targets, can be reduced.

The sputtering targets 23, 24 formed on both sides of the base 25 are sputtering targets 23, 24 for forming a protective layer in the multilayer film. Since the protective layer is formed after the reflective layer has been formed, the contamination of the target 21 or 22 by the sputtered atoms from the target 23 or 24 does not raise an important problem. Further, since the protective layer is to prevent the oxidation of the surface of the reflective layer, the problem is not so much even though the targets 23, 24 are contaminated by the sputtered atoms from the targets 21, 22.

In the ion beam sputtering apparatuses 1, 1', 1" shown in Figs. 1 to 3, vacuum pumps 100 are located at positions above the sputtering target 21 in the figures whereby a current of gas is created in the direction from the film deposition substrate 30 to the sputtering target 21, i.e., the opposite direction to the moving direction of the sputtered atoms 200 in the chamber 10. By this current of gas, particles from the inner walls and so on of the chamber 10 and particles generated at the ion sources 40 are led toward an upper side in the figures, i.e., a direction away from the film deposition substrate 30. Accordingly, the movement of the particles from the inner walls and so on of the chamber 10 and the movement of the particles generated at the ion sources 40 in the direction of the film deposition substrate 30 can be prevented.

In the ion beam sputtering apparatus 1 shown in Fig. 1, the particles from the inner walls and so on of the chamber 10 and the particles generated at the ion sources 40 are prevented from reaching the film deposition substrate 30 by determining the relative distance between the sputtering target 21 and the film deposition substrate 30 to be from 63 to 141 cm as described above. However, such an effect can further be increased by creating the current of gas.

Further, the current of gas from the film deposition substrate 30 to the sputtering target 21 may be created by raising the temperature of the film deposition substrate 30 more than the inner temperature of the chamber 10.

In the ion beam sputtering apparatuses 1, 1', 1" shown in Figs. 1 to 3, reflection plates are attached to the inner walls of the top and bottom of the chamber 10 so as to have an angle with the inner walls. These reflecting plates 70 are attached with certain angles so as to have inclination angles with respect to the inner walls of the chamber 10. Since the particles reaching the inner walls of the chamber 10 are led in a lateral direction in the figures, the movement of the particles toward the substrate 30 can be prevented.

In the ion beam sputtering apparatus 1' shown in Fig. 2, baffle plates 50 are provided at left and right sides in the figure, the movement of the particles toward the film deposition substrate 30 can further be prevented. The particles led to the left and right sides in the figure are trapped by the concave portions of the baffle plates 50. In the ion beam sputtering apparatuses 1, 1', 1" shown in Figs. 1 to 3, the reflecting plates 70 are provided on the top and bottom inner walls of the chamber 10. However, reflecting plates may be provided on the inner walls of left and right sides of the chamber 10.

Besides the above-mentioned structures, any structure or device useful for preventing particles from entering into the film during film formation can preferably be employed in carrying out the film deposition method of the present invention.

In a conventional ion beam sputtering apparatus, a rotating system is employed to rotate the film deposition substrate in order to obtain a uniform deposition. In the film deposition method of the present invention, a uniform deposition can be obtained by arranging a plurality of ion sources in symmetric positions. However, the film deposition substrate may be rotated by using such a rotating system as in the conventional apparatus if it is preferable in obtaining a uniform deposition.

However, when the rotating system is located in the chamber 10, particles may generate from the rotating system because of its mechanical design whereby the particles may enter into the film during film formation. Accordingly, use of the rotating system should be avoided as possible as long as a uniform deposition can be obtained without the rotating system.

When the rotating system is employed in the film deposition method of the present invention, it is necessary to prevent occurrence of particles from the rotating system. As measures for preventing particles from the rotating system, the film deposition substrate may be connected to the main body of the rotating system with a rotating shaft having a certain length, for example.

In the film deposition method of the present invention, it is preferred that the film deposition substrate has a low coefficient of thermal expansion (preferably, $0 \pm 1.0 \times 10^{-7}/°C$, more preferably, $0 \pm 0.3 \times 10^{-7}/°C$) and that it is excellent in smoothness, flatness and has resistance to a cleaning liquid used for, e.g., cleaning a mask blank or a patterned photomask. Specifically, the substrate comprises glass having a low coefficient of thermal expansion, such as $SiO_2$-$TiO_2$ glass. However, the substrate is not limited to such glass, but a substrate of crystallized glass with β quartz solid solution precipitated therein, quartz glass, silicon, metal may be employed

It is preferred from a viewpoint of obtaining a high reflectance and printing precision in a photomask after pattern formation that the film deposition substrate has a flat surface having a surface roughness of 0.2 nm or less in rms and a flatness of 100 nm or less. Further, the film deposition substrate has preferably a high rigidity in order to prevent the multilayer film, buffer layer and absorbing layer formed thereon from deforming it due to a membrane stress. Particularly, it is preferred that the substrate has a high Young's modulus of at least 65 GPa.

The dimensions, the thickness and the like of the film deposition substrate are properly determined according to the design values of a mask or the like. As a concrete example, a substrate has outer dimensions of 6 inch (152.4 mm) square and a thickness of 0.25 inch (6.3 mm).

The multilayer film formed by the film deposition method of the present invention can be selected widely from those required for the multilayer films for an EUV mask blank. The reflective layer may be a Mo/Si reflective layer, a Ru/Si reflective layer, a Mo/Be reflective layer, a Mo compound/Si compound reflective layer, a Si/Nb reflective layer, a Si/Mo/Ru reflective layer, a Si/Mo/Ru/Mo reflective layer or a Si/Ru/Mo/Ru reflective layer. In an example of the Mo/Si reflective layer, it is preferred that a Si film is deposited so as to have a thickness of $4.5 \pm 0.1$ nm, using a Si target as the target, using an Ar gas (having a gas pressure of $1.3 \times 10^{-2}$ Pa to $2.7 \times 10^{-2}$ Pa) as the sputtering gas, applying an ion acceleration voltage of 300 to 1,500 V and setting the film deposition rate at a value of 0.03 to 0.30 nm/sec, and then a Mo film is deposited so as to have a thickness of $2.3 \pm 0.1$ nm, using a Mo target as the target, using an Ar gas (having a gas pressure of $1.3 \times 10^{-2}$ Pa to $2.7 \times 10^{-2}$ Pa) as the sputtering gas, applying an ion acceleration voltage of 300 to 1,500 V and setting the film deposition rate at a value of from 0.03 to 0.30 nm/sec. On condition that the above-mentioned operation is one cycle, an operation of 30 to 60 cycles is carried out to laminate Si films and Mo films whereby a reflective layer (Mo/Si reflective layer) is formed.

On the reflective layer, a protective layer is formed by using the film deposition method for a multilayer film according to the present invention. The protective layer is effective to prevent the surface of the reflective layer from oxidizing. As concrete examples of the protective layer to be formed by using the film deposition method for a multilayer film of the present invention, a Si layer and a Ru layer can be exemplified.

When a material for the protective layer is the same as a material for the reflective layer, film deposition should be conducted so that the top layer is comprised of the material for the protective layer in the process for forming the reflective layer as described above. Specifically, in a case of a Mo/Si reflective layer, film deposition be conducted so that the top layer is comprised of a Si film whereby the protective layer comprising a Si layer can be formed. On the other hand, in a case of a Ru/Si reflective layer, film deposition be conducted so that the top layer is comprised of a Ru film, the protective layer comprising a Ru layer can be formed. When a material for the protective layer is different from a material for the reflective layer, the reflective layer is formed by the above-mentioned process, and then, ion beam sputtering be conducted by using a target material corresponding to the composition of the protective layer.

In manufacturing an EUV mask blank, a multilayer film is deposited on a film deposition substrate using the film deposition method of the present invention, and then, a buffer layer and an absorbing layer are deposited thereon in this order. These layers can be deposited by using a known film deposition method, specifically, a magnetron sputtering method or an ion beam sputtering method.

The material for the buffer layer may be, for example, Cr, Al, Ru, Ta, a nitride thereof, $SiO_2$, $Si_3N_4$ or $Al_2O_3$. It is preferred that the thickness of the buffer layer is from 10 to 60 nm.

As the material for the absorbing layer, Cr may be mentioned, for example. It is preferred that the thickness of the absorbing layer is from 50 to 100 nm.

In manufacturing an EUV mask blank, the stage of depositing the multilayer film by using the film deposition method of the present invention and the stages of forming the buffer layer and the absorbing layer which are conducted thereafter may be carried out in different chambers. In this case, a so-called dual-chamber type apparatus may be used. In the dual-chamber type apparatus, two chambers are connected by means of a load-lock and a mechanical device such as a robot or manipulator is employed to transfer a substrate between two chambers so that an enclosed environment can be provided. By using the dual-chamber type apparatus, EUV mask blanks can be produced without exposing film deposition substrates to an exterior environment.

INDUSTRIAL APPLICABILITY

According to the present invention, it is possible to prevent particles generated from inner walls or the like of the chamber and particles generated at an ion source from reaching a substrate during film formation. Accordingly, the present invention is preferably applicable to the manufacture of a reflective-type mask blank for EUV lithography.

The entire disclosure of Japanese Patent Application No. 2004-320284 filed on November 4, 2004 including specification, claims, drawings and summary is incorporated herein by reference in its entirety.

**Claims**

1. An ion beam sputtering apparatus comprising a chamber with a vacuuming device capable of maintaining the chamber in a vacuum state, a sputtering target made of a material forming a thin film deposited on the surface of a film deposition substrate and an ion source for irradiating ion beams comprising ions extracted from plasma onto the sputtering target,
the ion beam sputtering apparatus being **characterized in that** the sputtering target and the film deposition substrate are disposed at opposed positions so that the relative distance is from 63 to 141 cm.

2. An ion beam sputtering apparatus comprising a chamber with a vacuuming device capable of maintaining the chamber in a vacuum state, a sputtering target made of a material forming a thin film deposited on the surface of a film deposition substrate and an ion source for irradiating ion beams comprising ions extracted from plasma onto the sputtering target,
the ion beam sputtering apparatus being **characterized in that** the sputtering target and.the film deposition substrate are disposed at opposed positions with a predetermined space, and
the ion source is disposed at a position out of the region where particles move linearly from the film deposition substrate toward the sputtering target.

3. An ion beam sputtering apparatus comprising a chamber with a vacuuming device capable of maintaining the chamber in a vacuum state, a sputtering target made of a material forming a thin film deposited on the surface of a film deposition substrate and an ion source for irradiating ion beams comprising ions extracted from plasma onto the sputtering target,
the ion beam sputtering apparatus being **characterized in that** in the chamber, a device for deflecting ion beams by the action of a magnetic field is provided.

4. The ion beam sputtering apparatus according to Claim 1, 2 or 3 wherein a plurality of ion sources are provided so that they are symmetric with respect to the sputtering target.

5. The ion beam sputtering apparatus according to any one of Claims 1 to 4, wherein the width of the sputtering target is narrower than the width of the ion beams from the ion source.

6. The ion beam sputtering apparatus according to any one of Claims 1 to 5, wherein there are a sputtering target of high refractive index material and a sputtering target of low refractive index material as the sputtering target, and the sputtering target of high refractive index material and the sputtering target of low refractive index material are formed on a target-mounting base at positions opposed to each other.

7. The ion beam sputtering apparatus according to any one of Claims 1 to 6, wherein reflection plates are attached to an inner wall of the chamber at inclination angles.

8. A film deposition method for forming a multilayer film for a reflective-type mask blank for EUV lithography on a film deposition substrate by using an ion beam sputtering method, the film deposition method being **characterized in that** a sputtering target and a film deposition substrate are disposed at opposed positions so that the relative distance is from 63 to 141 cm.

9. A film deposition method for forming a multilayer film for a reflective-type mask blank for EUV lithography on a film deposition substrate by using an ion beam sputtering method, the film deposition method being **characterized in that** a sputtering target and a film deposition substrate are disposed at opposed positions with a predetermined space, and
ion beams are injected to the sputtering target from an ion source which is disposed at a position out of the region where particles move linearly from the film deposition substrate toward the sputtering target.

10. A film deposition method for forming a multilayer film for a reflective-type mask blank for EUV lithography on a film deposition substrate by using an ion beam sputtering method, the film deposition method being **characterized in that** a sputtering target and a film deposition substrate are disposed at opposed positions with a predetermined space, and
ion beams from an ion source are deflected by the action of a magnetic field to be injected into the sputtering target.

11. A film deposition method for forming a multilayer film for a reflective-type mask blank for EUV lithography on a film deposition substrate by using an ion beam sputtering method, the film deposition method being **characterized in that** temperature changes in the vacuum atmosphere in ion beam sputtering are kept to be less than 10°C.

12. The film deposition method for forming a multilayer film for a reflective-type mask blank for EUV lithography on a film deposition substrate by using an ion beam sputtering method according to any one of Claims 8 to 11, wherein a defect of 30 nm or larger in the multilayer film is at most 0.05 number/cm$^2$.

13. A multilayer film for a reflective-type mask blank for EUV lithography, formed by the method according to any one of Claims 8 to 12.

EP 1 808 509 A1

Fig. 1

Fig. 2

## Fig. 3

**INTERNATIONAL SEARCH REPORT**

| International application No. |
| --- |
| PCT/JP2005/019406 |

| A. CLASSIFICATION OF SUBJECT MATTER |
| --- |
| *C23C14/46*(2006.01), *C23C14/34*(2006.01), *G03F1/16*(2006.01), *H01L21/027* (2006.01), *H01L21/285*(2006.01) |

According to International Patent Classification (IPC) or to both national classification and IPC

| B. FIELDS SEARCHED |
| --- |
| Minimum documentation searched (classification system followed by classification symbols) |
| *C23C14/46*(2006.01), *C23C14/34*(2006.01), *G03F1/16*(2006.01), *H01L21/027* (2006.01), *H01L21/285*(2006.01) |

Documentation searched other than minimum documentation to the extent that such documents are included in the fields searched
Jitsuyo Shinan Koho         1922-1996    Jitsuyo Shinan Toroku Koho    1996-2006
Kokai Jitsuyo Shinan Koho   1971-2006    Toroku Jitsuyo Shinan Koho    1994-2006

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| Y | JP 10-287973 A  (Olympus Optical Co., Ltd.), 27 October, 1998 (27.10.98), Claim 2; Par. Nos. [0007], [0010], [0080] (Family: none) | 1,8 |
| Y | JP 7-90579 A  (Japan Aviation Electronics Industry Ltd.), 04 April, 1995 (04.04.95), Claims; Par. Nos. [0007], [0012], [0014] (Family: none) | 2,4,7,9 |
| Y | JP 2000-178731 A  (Japan Aviation Electronics Industry Ltd.), 27 June, 2000 (27.06.00), Claims; Fig. 1 (Family: none) | 6,12,13 |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search   31 January, 2006 (31.01.06) | Date of mailing of the international search report   07 February, 2006 (07.02.06) |
| --- | --- |
| Name and mailing address of the ISA/   Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2005/019406 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 8-127869 A  (Japan Aviation Electronics Industry Ltd.), 21 May, 1996 (21.05.96), Claims (Family: none) | 3,5,10 |
| Y | JP 2002-216653 A  (Hitachi, Ltd.), 02 August, 2002 (02.08.02), Claims; Par. No. [0047] (Family: none) | 11 |
| A | JP 8-81771 A  (Nikon Corp.), 26 March, 1996 (26.03.96), Claims | 1-13 |

Form PCT/ISA/210 (continuation of second sheet) (April 2005)

## INTERNATIONAL SEARCH REPORT

| International application No. |
|---|
| PCT/JP2005/019406 |

**Box No. II**     **Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III**     **Observations where unity of invention is lacking (Continuation of item 3 of first sheet)**

This International Searching Authority found multiple inventions in this international application, as follows:

    All the inventions in claims 1-11 relate to ion beam sputtering equipment
or a method for manufacturing a multilayer film using such equipment. The
special technical feature of the invention in claims 1 and 8 is of setting
a relative distance between a sputtering target and a substrate within a
specific range, while that of the invention in claims 2 and 9 is of specifying
an arrangement position of an ion source and that in claims 3 and 10 is of
deflecting an ion beam.
    Since there is no same or corresponding relationship among these special
technical features, these inventions are not considered to be linked to form
a single general inventive concept.

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**     ☐ The additional search fees were accompanied by the applicant's protest and, where applicable,
the     payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002222764 A
- JP 2004246366 A
- JP 7090579 A
- JP 2004137557 A
- JP 2004320284 A